(19) Europäisches Patentamt

European Patent Office

Office européen des brevets

(11) **EP 1 047 008 A2**

(12) **EUROPEAN PATENT APPLICATION**

(43) Date of publication:
25.10.2000 Bulletin 2000/43

(51) Int. Cl.⁷: **G06F 17/50**

(21) Application number: **00303040.0**

(22) Date of filing: **11.04.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **20.04.1999 US 295252**

(71) Applicant:
**LUCENT TECHNOLOGIES INC.**
**Murray Hill, New Jersey 07974-0636 (US)**

(72) Inventor:
**Huelsbergen, Lorenz Francis**
**Hoboken, New Jersey 07030 (US)**

(74) Representative:
**Watts, Christopher Malcolm Kelway, Dr. et al**
**Lucent Technologies (UK) Ltd,**
**5 Mornington Road**
**Woodford Green Essex, IG8 0TU (GB)**

(54) **Method and apparatus for configuring dynamic graph processors**

(57) A method and apparatus for implementing a dynamic graph processor in reconfigurable hardware. A circuit representing a directed graph is maintained in a reconfigurable hardware array such that the circuit maintains the graph as a collection of gates and wires thereby facilitating dynamic modification of the graph and allowing for the properties of the graphs to be quickly queried.

*FIG. 3*

**Description**

**Field of the Invention**

The present invention relates to graph data structures and, more particularly, to configuring and representing dynamic graphs in hardware.

**Background of the Invention**

Graphs are well-known central data structures, see, e.g., T. H. Cormen et al., *Introduction to Algorithms*, MIT Press, 1990, useful in a variety of applications. For example, in integrated circuit and hardware design, well-known graph algorithms compute critical routing and placement information, see, e.g., T. Kean et al., "Using CAL to accelerate maze routing of CAL designs", In *Proceedings of 2nd Int. Workshop on Field Programmable Logic and Applications*, pp. 1-4, 1992, which is hereby incorporated herein by reference for all purposes. In terms of computing, graph algorithms deduce connectivity in networks, compute the closure of relations in databases, and manage storage in operating systems and programming languages, among many other applications. Solving well-known graph problems, e.g., reachability, transitive closure, shortest unit path, connected-component and cycle identification, is one important use of graphs in the above-described applications.

For example, compiling graphs into specialized hardware circuits to attain rapid property computation, e.g., transitive closure, has been previously explored in S. T. Chakradhar et al., "A novel VLSI solution to a difficult graph problem", In *Fourth International Symposium on VLSI Design*, IEEE, pp. 124-129, January 1991, which is hereby incorporated herein by reference for all purposes. Chakradhar describes a graph-circuit transformation for computing a graph's independent sets and suggests reconfigurable hardware, e.g., well-known field programmable gate arrays ("FPGA"), as a means for utilizing such transformations. In addition, J. Babb et al., "Solving graph problems with dynamic computation structures", In *SPIE Photonics East: Reconfigurable Technology for Rapid Product Development & Computing*", pp. 225-236, November 1996, which is hereby incorporated herein by reference for all purposes, describes graph-circuit transformations for shortest path and transitive closure wherein they synthesize and stimulate resultant circuits, e.g., FPGA's. However, a common feature of the above-described prior approaches for encoding graphs in static or reconfigurable hardware is the exclusive use of so-called "static graphs". That is, in each approach, a fixed graph is first transformed to a circuit and then fitted, i.e., placed and routed, to the hardware before any queries regarding the graph are processed. When the graph is subsequently modified, for example, by vertex and edge insertions and deletions, these schemes require a recompilation to the hardware. As will be appreciated, such a recompilation process is a significant overhead penalty in terms of time in the reconfiguration of integrated circuits.

In Kean *supra.*, a dynamic scheme, particular to the application of routing circuits, is described directed to routing multiple "nets" (i.e., circuits consisting of nodes and wires) onto a FPGA with NxN cells. Kean models the FPGA as a circuit (which is then itself instantiated on an FPGA) such that when a routing resource is being used in the routing of a particular net that resource is disabled for other nets in the modeling circuit. Thus, Kean's scheme solves reachability in a two dimensional mesh of cells where some cells are missing (i.e., in use by other circuits and therefore disabled). While this scheme is effective in routing multiple nets, certain drawbacks/constraints exist in applying Kean's approach to complex graphs and/or circuit arrangements: (1) the approach is not inherently graph based; (2) cell reachability is computed in a restricted domain, i.e., two-dimensional meshes with certain prescribed connectivity; (3) the scheme does not allow for the random insertion and/or deletion of wires, i.e., edges, between circuit nodes without dismantling the current circuit; and (4) the analysis of further graph properties, e.g., transitive closure or shortest path, is not specifically addressed.

Therefore, a need exists for a technique for configuring and maintaining dynamic graphs, expeditiously querying such graphs, and dynamically reconfiguring such graphs for use in reconfiguring hardware devices such as integrated circuits.

**Summary of the Invention**

The present invention provides a method and apparatus for implementing a dynamic graph processor (hereinafter also referred to as "DGP") in reconfigurable hardware. More particularly, in accordance with an aspect of the invention, a circuit representing a directed graph is maintained in a reconfigurable hardware array. Further, the circuit maintains the graph as a collection of gates and wires connecting the gates which facilitates dynamic, i.e., real-time, modification of the graph and allows the properties of the graphs to by quickly queried.

In accordance with the preferred embodiment of the invention, a DGP is configured as a function of a active-adjacency matrix (hereinafter also referred to as "AAM") embodying the adjacency-matrix representation of a directed graph and locating vertices at known locations in the reconfigurable hardware array. In accordance with the preferred embodiment of the invention, a directed graph is defined and mapped to a AAM network, illustratively, through the insertion of the relevant edges as defined by the directed graph in AAM network. More particularly, in accordance with the preferred embodiment, a AAM distributor network and AAM collector network are combined to form a complete AAM network such that the source signal of a vertex $v_i$ propagates down the $i$th column to every cell in the $i$th row of the AAM network. As such, when an edge, of the directed graph, from $v_i \rightarrow v_j$ exists the crossing at $(j,i)$ within AAM network, i.e., the DGP, will contain a physical connection representing the particular edge.

Advantageously, the various aspects of the invention provide a dynamic graph configuration which facilities real-time graph modification which are instantaneously reflected in hardware. Thus, the properties of such graphs are dynamically explored and studied.

## Brief Description of the Drawings

FIG. 1 shows an illustrative directed graph to which the principles of the invention apply;
FIG. 2 shows an illustrative circuit resulting from applying a well-known static circuit construction to the directed graph of FIG. 1;
FIG. 3 is a flowchart of illustrative operations performed in accordance with the invention for representing and constructing dynamic graphs processors in reconfigurable hardware;
FIG. 4 shows an illustrative AAM distributor network, AAM collector network, and complete AAM network, configured in accordance with the principles of the invention;
FIG. 5 shows an illustrative vertex construction, in accordance with the various aspects of the invention, for the vertices of the AAM network of FIG. 4;
FIG. 6 shows the complete DGP containing the full AAM network, as configured in accordance with the principles of the invention, for the illustrative directed graph of FIG. 1;
FIG. 7 shows an illustrative configuration of a modified full AAM network and graph after edge deletion and insertion operations are performed, in accordance with the invention, on the DGP of FIG. 6; and
FIG. 8 contains illustrative simulation comparison results of analyzing the reachability of a graph in accordance with the principles of the invention relative to a conventional uniprocessor software implementation.

Throughout this disclosure, unless otherwise noted, like elements, blocks, components or sections in the figures are denoted by the same reference designations.

## Detailed Description

The present invention provides a method and apparatus for implementing a dynamic graph processor in reconfigurable hardware. More particularly, in accordance with the invention, a circuit representing a directed graph is maintained in a reconfigurable hardware array. Further, the circuit maintains the graph as a collection of gates and wires connecting the gates which facilitates dynamic, i.e., real-time, modification of the graph and allows the properties of the graphs to by quickly queried.

It should be noted that for clarity of explanation, the illustrative embodiments described herein are presented as comprising individual functional blocks or combinations of functional blocks. The functions these blocks represent may be provided through the use of either shared or dedicated hardware, including, but not limited to, hardware capable of executing software. Illustrative embodiments may comprise digital signal processor ("DSP") hardware and/or software performing the operations discussed below. Further, in the claims hereof any element expressed as a means for performing a specified function is intended to encompass any way of performing that function, including, for example, a) a combination of circuit elements which performs that function; or b) software in any form (including, therefore, firmware, object code, microcode or the like) combined with appropriate circuitry for executing that software to perform the function. The invention defined by such claims resides in the fact that the functionalities provided by the various recited means are combined and brought together in the manner which the claims call for. Applicant thus regards any means which can provide those functionalities as equivalent as those shown herein.

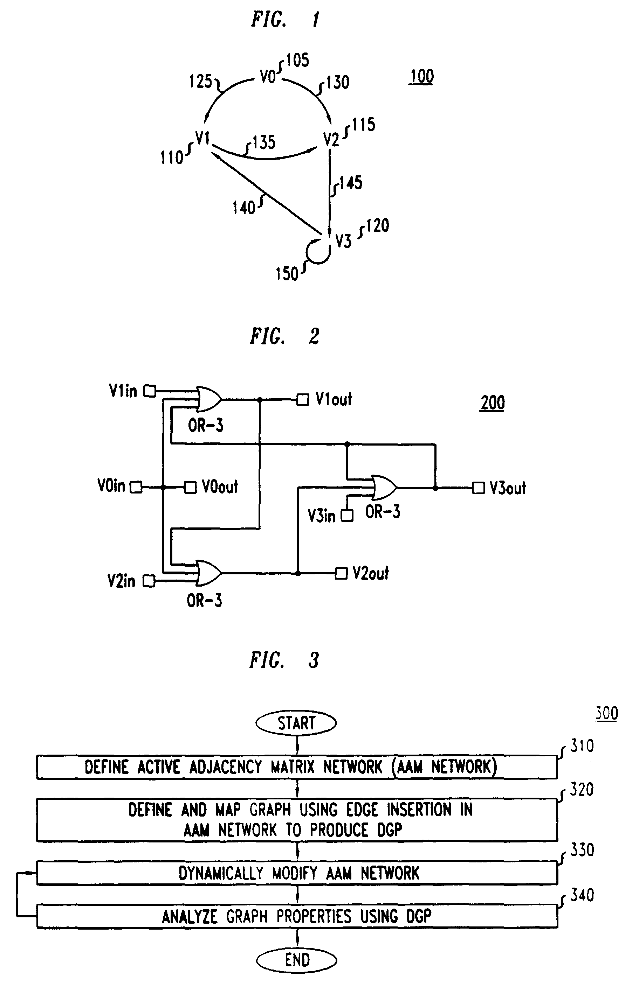

FIG. 1 shows an illustrative directed graph "$G$" 100 to which the principles of the invention apply. More particularly, directed graph 100 has four vertices 105, 110, 115 and 120, respectively, and six edges 125, 130, 135, 140, 145, and 150, respectively. Among many well-known graph properties, one may wish to analyze so-called reachability information about the structure of directed graph 100. As is well-known, reachability is directed to determining whether there is a path from one vertex in a graph to another vertex in the graph. For example, one reachability query into the structure of directed graph 100 is whether there is a path such that vertex 105 reaches vertex 120. Alternatively, it may also be of interest to determine the length of the so-called shortest unit path that connects a pair of vertices, e.g., vertex 110 and vertex 115, respectively. Moreover, upon edge and vertex insertions and/or deletions one may wish to recompute various graph properties, e.g., reachability and/or shortest unit path.

Software algorithms for computing such properties are well-known, see, e.g., Cormen *supra.* at p. 87 and pp. 514-549, and can compute reachability and shortest unit path in processing time proportional to the size of the input graph. This processing time includes a constant which represents the costs of manipulating the graph's software representation (including the non-trivial costs associated with fetching this representation into the processor). This constant is large relative to the constraints, e.g., signal propagation or gate delay, involved in general with electronic circuits and, more particularly, with graph circuits. Thus, such software-only applications for analyzing graph properties have certain drawbacks. Furthermore, uniprocessor software implementations can only traverse a single edge at a time even though the search could naturally proceed through multiple outgoing edges (and potentially in multiple sections of the graph) concurrently.

Alternatively, a multiprocessor having parallel software, can explore a number of paths in parallel typically bounded by the number of parallel processing elements. However, a multiprocessor must coordinate and synchronize the parallel graph traversal thereby incurring certain processing overhead. Further, as is well-known, parallel graph algorithms exist for various processing networks, see, e.g., F. T. Leighton, *Introduction to Parallel Algorithms and Architectures: Arrays, Trees, and Hypercubes*, Morgan-Kaufmann, 1992, but these require explicit synchronization and communication.

Further, applying well-known static circuit construction techniques to the graph, see, e.g., Babb, *supra*. at p. 228, also has certain disadvantages. More particularly, given a source vertex $v_i$ in a directed graph, e.g., directed graph 100, graph reachability computes the set of vertices $R(v_i)$ reachable from $v_i$ : $R(v_i) = \{v_j| v_i \rightarrow v_j\}$. To directly construct a static circuit of directed graph 100 to solve reachability, the edges of directed graph 100 are replaced with wires, and every $n$-input, $m$-output vertex in the directed graph is replaced with an $n$-input logical OR-gate fanning to the $m$ outgoing edges, i.e., wires. FIG. 2 shows illustrative circuit 200 resulting from applying such a well-known static circuit construction to directed graph 100. As stated previously, such static circuit construction has certain disadvantages. For example, the direct construction does not permit efficient vertex and edge modifications to the directed graph. This is because the circuit, e.g., circuit 200, is "hardwired" and the placement of OR-gates, i.e., vertices, and the routing of wires, i.e., edges, is circuit dependent. Thus, complex routing and placing operations are required to map the logical circuit to the physical hardware. Further, gate or wiring changes require rerouting and replacing the circuit design. Difficulties arise in performing updates on this construction in the that the resources between gates, i.e., wires, may be restricted from future connection with new gates therefore requiring gate relocation to establish such the requisite connections. Similarly, removing a route in the direct construction may require multiple (perhaps non-local) modifications.

In contrast, and advantageously, the various aspects of the present invention directed to the construction and implementation of DGP's are achieved with minimal processing overhead and allow for the dynamic changing of graphs with instantaneous representation of the modified graph directly in hardware, as is further discussed in greater detail below.

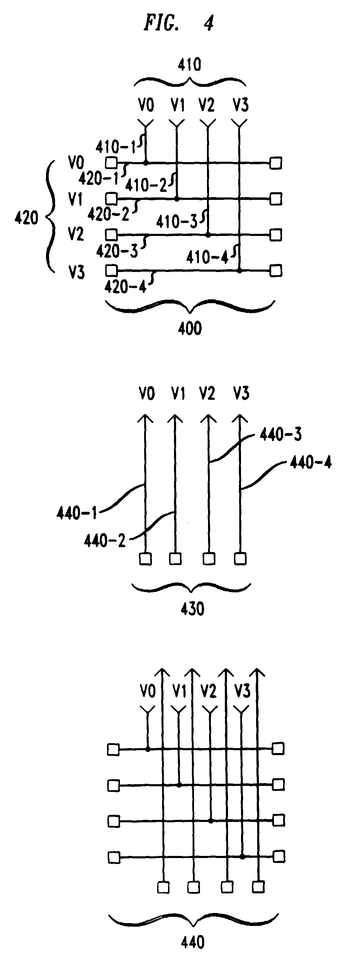

Turning our attention to FIG. 3 and FIG. 4, the various aspects of the invention for mapping graphs to reconfigurable hardware, e.g., circuits, and allowing for dynamic modifications of those graphs will now be discussed. FIG. 3 is a flowchart of illustrative operations 300 performed, in accordance with the invention, for implementing dynamic graph processors in reconfigurable hardware. More particularly, I have realized that the so-called adjacency-matrix representation of a graph can be used in conjunction with a particular circuit layout configuration to produce a DGP which enables my novel transformation of graphs to circuits. The adjacency-matrix representation, see, e.g., Cormen *supra.* at p. 467, is a $|V|$ by $|V|$ matrix $A = (a_{i,j})$ such that:

$$(1) \qquad a_{i,j} \;=\; \begin{cases} 1 & \text{if } (i,j) \in E \\ 0 & \text{otherwise} \end{cases}.$$

That is, $a_{i,j}$ is "true" if a directed edge from $i$ to $j$ exists in the graph, otherwise, $a_{i,j}$ is "false". As will be appreciated, this adjacency-matrix representation requires $O(|V|^2)$ space to hold a complete graph. I have realized that this representation can be used in conjunction with reconfigurable hardware, e.g., field programmable gate arrays, to supply interconnect and glue logic for the construction of DGP's thereby facilitating the dynamic modification of graphs and studying the properties of such dynamic graphs.

More particularly, in accordance with the invention, a active-adjacency matrix embodies the adjacency-matrix representation and locates vertices at fixed locations in the reconfigurable hardware array. In accordance with the preferred embodiments of the invention, this hardware array is a standard FPGA, e.g., the XC6200 FPGA family available from the Xilinx, Inc., 2100 Logic Drive, San Jose, CA 95124 or similar such FPGA's available from a variety of other well-known semiconductor device suppliers, and permits a directed edge between any two vertices thereby supporting complete graphs. Of course, it will be understood that the various aspects of the invention are also equally applicable to other hardware arrangements, e.g., custom application specific integrated circuits ("ASIC") or optical laser circuitry. Edge insertion and deletion operations in an active-adjacency matrix are $O(1)$ time operations with constant-time array indexing. In accordance with the invention, for an AAM, these operations will address, i.e. select, a particular cell or set of cells in the reconfigurable hardware array and replace, i.e., write, a new set of values to the cell(s).

In accordance with the preferred embodiment of the invention, a processing arrangement is employed which incorporates, *inter alia.*, a host processor working in conjunction with the DGP. As will be appreciated, the host processor can be any standard processor, microprocessor, digital signal processor and the like. In this processing arrangement of the preferred embodiment, the DGP mirrors the structure of the relevant directed graph which is also maintained (in the same or using other well-known graph structures) on the host processor. Operations on the graph are initiated by the host processor and reflected by the DGP. The host processor also performs requisite operations such as "bookkeeping" tasks, e.g., maintaining the set of free vertices in the DGP. In accordance with the invention, queries of graph properties may be resolved by consulting the DGP rather than traversing the host processor's representation with a software algorithm.

Further, in accordance with the invention, vertex deletion of the graph in the AAM representation involves $O(|V|)$ operations. That is, to delete vertex $v$, the row and column corresponding to $v$'s in and out edges must be removed. For example, such removal of the edges will employ $2|V|-1$ matrix operations. However, if, for every active vertex $v$, the host processor maintains an edge incidence set $I_v$ of the edges entering and leaving $v$, deletion of $v$ may be performed in $O(|I_v|)$ operations. For example, the incidence sets $I$ can be maintained on the host processor using well-known dictionaries, see, e.g., Cormen *supra.* at pp. 263-280, such that the incidence set for vertex $v$ may be updated in worst case time $O(\log_2|E|)$ per edge insertion/deletion operation involving $v$, where $E$ is the set of edges in the graph.

Further, in accordance with the invention, vertex insertion to the graph in the AAM representation involves either locating an unassigned vertex in the matrix, or, failing that, extending the matrix by adding a row and column. In accordance with the preferred embodiment of the invention, the maximum vertex capacity of the matrix in the AAM is set to a fixed value. In addition, in accordance with the preferred embodiment, AAM vertex insertion is handled primarily by the host processor which maintains a list of free vertices in the DGP. Vertex deletion places the prior, now unused, DGP location on the list such that new locations for vertex insertion are taken from this list. Thus, vertex insertion can be performed by the host processor and AAM in constant time.

Turning our attention back to FIG. 3, in accordance with preferred embodiment of the invention, the active-adjacency matrix network is defined (block 310) consistent with the above-described vertex manipulation and timing discussion and using a structure which includes a AAM distributor network and a AAM collector network. In accordance with this aspect of the invention, the AAM distributor network distributes the input signal at a particular vertex $v$ along $v$'s outgoing edges to its immediate successor vertices. The AAM distributor network constitutes the vertices' outgoing edges.

Turning our attention briefly to FIG. 4, an illustrative AAM distributor network 400 is shown configured, in accordance with the invention, with a series of columns 410 and rows 420. In particular, AAM distributor network 400 is illustratively configured as a four vertex graph (see, directed graph 100 of FIG. 1) with the four vertices, $v_0$, $v_1$, $v_2$, and $v_3$ shown aligned with columns 410-1 through 410-4, respectively. Further, rows 420-1 through 420-4 are also aligned with vertices, $v_0$, $v_1$, $v_2$, and $v_3$, respectively, as shown in FIG. 4. It will be noted and understood, that throughout the balance of this disclosure such rows and columns will be alternatively referred to by the vertex $v$ with which the row or column is aligned. For example, column 410-1 also will be referred to as vertex $v_0$. In accordance with further embodiments of the invention, larger AAM distributor's are configured by adding columns to the right of column 410-4, i.e., vertex $v_3$, and rows on the bottom, i.e., below row 420-4, of AAM distributor network 400. Further, the complete AAM network, see, e.g., AAM network 440, has associated with every vertex an input for the incoming value and an output for the outgoing value. In accordance with the preferred embodiment, AAM distributor network 400 contains the input line, and for vertex $v_i$ in column $i$, AAM distributor network 400 routes the value from this line to row $i$ of AAM network 440. That is, the value of $v_i$ is made available to another vertex $v_j$ by a potential connection at $(j,i)$. As will be discussed further below, in accordance with the invention, such a connection is made with another network, in particular, AAM collector network 430 which provides vertex outputs.

More particularly, AAM collector network 430 is illustratively shown as a four vertex (440-1, 440-2, 440-3, and 440-4, respectively) collector network which serves to route values in to a particular vertex. In accordance with the preferred embodiment of the invention, values carried by AAM collector network 430 stem from AAM distributor network 400 and are routed onto AAM collector network 430 through graph-specific collector-distributor connections as further discussed below. As with AAM distributor network 400, the size of AAM collector network 430 is increased by lengthening the collection wires and adding vertices, i.e., wires, to the right of vertex 440-4, i.e., $v_3$.

In accordance with the invention, AAM distributor network 400 and AAM collector network 430 are combined to form the complete AAM network 440 such that the source signal of a vertex $v_i$ propagates down the $i$th column to every cell in the $i$th row of AAM network 440. As such, a physical connection is made in AAM network 440 when an edge from $v_i \rightarrow v_j$ exists at the crossing at $(j,i)$ within the network. As shown in FIG. 4, AAM network 440 is in a so-called "empty" graph state in that there are no connections depicted between the distributor and collector. In accordance with the invention, AAM network 440 is employed for configuring the DGP and facilitating the dynamic direct mapping of graphs to circuits.

More particularly, turning our attention back to FIG. 3, after defining the AAM network (block 310) as detailed above, the particular graph is defined (block 320) which defines the requisite vertex information and relationships, see, e.g., directed graph 100 of FIG. 1. Thereafter, in accordance with the invention, the graph is further defined and mapped within AAM network 440 to produce a complete AAM network for the graph (block 320). In accordance with the preferred embodiment of the invention, this graph definition and mapping in AAM network 440 is executed through the insertion of the relevant edges in AAM network 440 as defined by the graph, e.g., directed graph 100. For example, suppose one wanted to perform a reachability analysis on a graph. In accordance with the preferred embodiment, a graph $G = (V, E)$ is embedded in AAM network 440 such that an edge $e \in E$ from vertex $v_i \rightarrow v_j$ will connect the distributor subnet, i.e., AAM distributor network 400, emanating from $v_i$ to the collector subnet, i.e., AAM collector network 430, feeding into $v_j$.

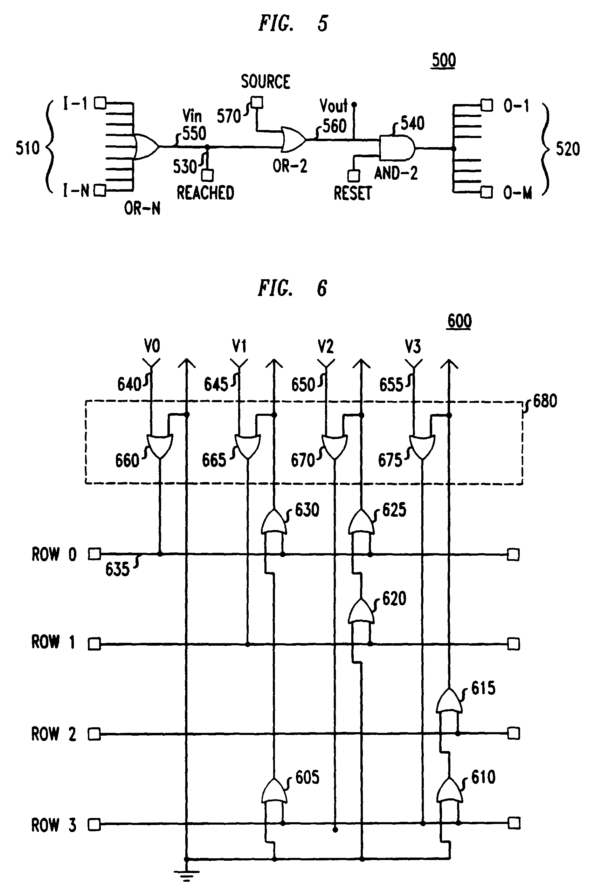

As multiple edges may enter a vertex, OR-gates are used, in accordance with the preferred embodiment, to combine values along multiple incoming edges. Further, in accordance with the preferred embodiment of the invention, for each vertex, the source of a vertex is separated from its input edges with an additional two-input OR-gate. In this way, a vertex is reachable from the source if its so-called "reached" output is high. For example, FIG. 5 shows an illustrative vertex construction 500 in accordance with the various aspects of the invention. In particular, vertex construction 500 is configured to support the above-described vertex self reachability features of the invention. That is, vertex construction 500 supports $n$ input edges 510 and $m$ output edges 520 such that $V_{in}$ is set high if the vertex is the source of a reachability query (see, e.g., $V_{in}$ 550), otherwise, it is set low. Similarly, a vertex's $V_{out}$ registers high if it is reachable from the source vertex (see, e.g., $V_{out}$ 560). In addition, vertex construction 500 contains reset logic 540 to clear cycles through the vertex. As described above, a vertex is reachable from source 570 if its reached output 530 is high.

Turning our attention, again, back to FIG. 3, as the graph definition and mapping in AAM network 440 is executed, in accordance with the preferred embodiment, through the insertion of the relevant edges in AAM network 440, vertex construction 500 plays an important in the final definition of the full AMM network for the graph. Illustratively, FIG. 6 contains the complete AAM network 600 for the four-vertex directed graph 100 as configured in accordance with invention. The four vertices 640-655 (labeled as $v_0$ - $v_3$, respectively) appear across the top of AAM network 600. As one can see from AAM network 600, OR-gates 605-630 each respectively form connections, i.e., edges, between vertices of graph 100. Thus, an OR-gate in AAM network 600 corresponds directly to a non-zero entry in the graph's regular adjacency-matrix as discussed above. Further, OR-gates 660-675, respectively, are specific to the vertex reachability graph property as described above and combine the source vertex with the values on incoming edges and thereafter propagate this combined value onto the vertex's outgoing edges. Further, with respect to OR-gates 660-675, these gates collectively form glue logic 680 which is used to dynamically change the mapping of AAM network 600 for analyzing different graph properties. That is, changes to glue logic 680, in accordance with further embodiments of the invention discussed below, facilitates the study of additional graph properties such as transitive closure, shortest unit path, connected components, and cycle detection.

In terms of the illustrative embodiment of AAM network 600, the coordinate system for determining the positions $(j,i)$ has the position $(0,0)$ designated in the upper left corner of this configuration. Thus, when the graph contains an edge from $v_i \rightarrow v_j$, the AAM distributor network connects to the AAM collector network with an OR-gate at position $(j,i)$. The inputs to the gate are the collector/distributor lines, from vertex $i$, at that position and its output is the collector line for vertex $j$. For example, OR-gates 630 and 625, respectively, in row 635 connect the output of $v_0$ to the inputs $v_1$ and $v_2$, respectively. Further, for example, OR-gate 610 and 615, respectively, serve to combine the values entering $v_3$ from itself and from $v_2$ via $v_3$, $v_2$ distribution wires respectively.

As discussed above, the configuration of AAM network 600 provides for the dynamic modification (see, FIG. 3, block 330) and analysis of the graph (see, FIG. 3, block 340) in accordance with various aspects of the invention. Illustratively, AAM network 600 and its associated graph may be readily modified through edge insertions and deletions. As such, the dynamic modification and analysis (see, e.g., FIG.3 blocks 330 and 340) of the AAM network and graph, in accordance with the invention, can continue for an unlimited number of iterations. Thus, numerous modifications to the graph in the DGP can be made together with the recomputation and analysis of the desired graph property. For example, consider the deletion of the edge $v_1 \rightarrow v_2$. In AAM network 600, the OR-gate at position $(2,1)$, i.e., OR-gate 620, is rewritten with a wire that connects the left input from the $v_2$ collector to the left input of the OR-gate at position $(2, 0)$, i.e., OR-gate 625. The $v_1$ distributor wire into the rewritten gate's right input is also deleted by this operation. Thus, the modification consists of indexing into AAM network 600 and rewriting the functionality of the logic and routing as the target location. In accordance with the preferred embodiment, AAM network 600 is illustratively configured in a FPGA where such rewriting and routing modification is supported in the hardware itself. Continuing with this example, suppose now that edge $v_0 \rightarrow v_3$ is inserted. In accordance with the preferred embodiment, a new OR-gate is written into position (3,0) of AMM network 600 with the left input from the $v_3$ collector and right input from the $v_0$ distributor output.

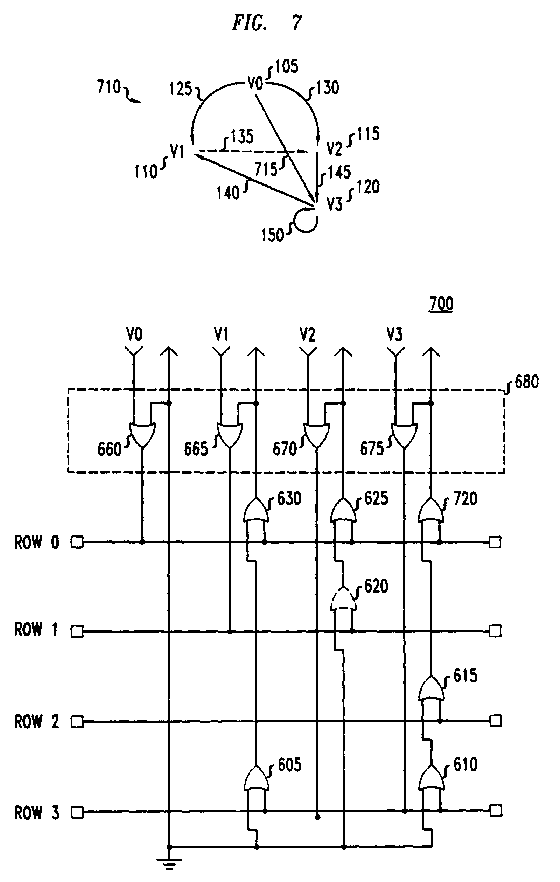

FIG. 7 shows an illustrative configuration of the modified complete AAM network 700 and directed graph 710 after the above-described edge deletion and insertion operations are performed, in accordance with the invention, on AMM network 600. In particular, directed graph 710 shows the deletion of edge 135 (shown in dashed lines for explanation purposes) and addition of edge 715 as described above. Such edge deletion and addition operations are further reflected in AAM network 700 which illustratively shows the deletion of OR-gate 620 (shown in dashed lines for explanation purposes) and the addition of OR-gate 720.

As discussed above, the various aspects of the invention provide a novel dynamic graph configuration which facilities real-time graph modification which are instantaneously reflected in hardware. In addition, in accordance with the invention, the properties of such DGP graphs are dynamically explored and studied. The following discussion is directed at further details regarding the above-described reachability aspects of the invention, as well as, discussing further aspects of the invention for examining graph properties such as: transitive closure, shortest unit path, connected components, and cycle detection. As mentioned above, illustratively, glue logic 680 is used to dynamically change the mapping of AAM network 600 for analyzing such different graph properties.

In accordance with the preferred embodiment of the invention, DGP graph reachability is analyzed in terms of gate and signal propagation delays. As will be appreciated, this analysis is in stark contrast to conventional graph reachability schemes which count algorithm steps. Thus, in accordance with this aspect of the invention, reachability in a graph is bounded by the number of vertices $n = |V|$. That is, in worst case, a DGP graph must propagate a signal along $n$ edges serially. In particular, the time required in a worst case propagation of a signal along a single edge in accordance with this aspect of the invention is given by:

$$T = T_d(n) + T_c(n) \qquad (2)$$

where $T_d(n)$ is an upper bound on the time to propagate along a distributor wire of length $O(n)$. Likewise, $T_c(n)$ is an upperbound on the time to propagate along a collector wire, containing up to $n$ gates for distributor-collector connections, of length $O(n)$. Therefore, in accordance with this embodiment of the invention, reachability can be computed in time $nT$.

A reduction in the above-described reachability time for graph queries is achieved by using so-called "stasis detection". That is, stasis detection can be used to reduce reachability time for graph queries from a vertex $v_i$ that need not traverse the worst case path, i.e., a vertex passing from $v_i$ to $v_j$ with fewer than $n - 2$ intermediate nodes. Essentially, stasis detection allows for the detection of when the reachability analysis is complete. Thus, in accordance with a further reachability embodiment of the invention, at regular intervals, a stasis detection circuit is applied in the AAM network, e.g., AAM network 600, which synchronously monitors the signal arriving at a vertex. The stasis detection circuit captures the current signal and compares it to the signal captured at the previous interval. If the signal values differ at any vertex, the reachability computation is still incomplete. In accordance with this embodiment of the invention, the sampling interval of the stasis detection circuit is selected as a function of $T$ as described in equation (2) above. In particular, the sampling interval (i.e., the maximum edge propagation time to ensure that two consecutive samples allow time for traversal of the longest edge) is selected to be at least as large as $T$.

In accordance with this embodiment of the invention, the stasis detection circuit is preferably implemented with a AND-comparator and a register at every vertex of the AAM network along with a combining tree of AND-gates whose single output is asserted if the values at the vertices did not change from the last sample. The depth of the combining tree is computed illustratively as $\log_2(|V|)$ and contains $O(|V|)$ gates.

In accordance with a further aspect of the invention, transitive closure of a graph is analyzed as a function of a DGP. In particular, transitive closure for a directed graph, $G = (V, E)$, is defined as the graph $G^* = (V, E^*)$ where $E^* = \{(i,j) : \exists \text{ path from } v_i \text{ to } v_j \text{ in } G\}$. The adjacency matrix $E^*$ is constructed in $n$ reachability steps by computing the $n$ vectors of vertices reachable from each $v_i$, for $0 \le i < n$. In accordance with this embodiment, a single such vector is computed asynchronously and in parallel using the DGP reachability operations and their algorithmic time complexity as previously discussed. As such, transitive closure has a complexity of $O(n^2 T)$.

The so-called shortest unit path graph property is analyzed, in accordance with a further embodiment of the invention, by computing the length (not the path itself) of the shortest unit path from $v_i$ to $v_j$. In accordance with this embodiment of the invention, the OR-gate at each vertex, see, e.g., FIG. 6, OR-gates 640-655, which gates the collector signal to the distributor signal is replaced with a so-called "clocked latch". That is, the signal reaching a vertex $v$ is clocked into the latch every clock period and only then injected into $v$'s distributor on an asynchronous basis. After initially asserting a signal at $v_i$, the circuit is clocked until either the signal propagates to $v_j$ or $n = |V|$ clocks have issued. In the former instance, the number of issued clocks corresponds to the length of the shortest unit path from $v_i$ to $v_j$. In the latter instance, no path from $v_i$ to $v_j$ exists. As a clock can be issued after waiting a time slightly greater than the worst case propagation delay $T$ (as described above in equation (2) in conjunction with stasis detection), computing the length of the shortest unit path requires at the most time $O(nT)$.

As is well-known, the so-called connected component $C$ in an undirected graph $G$ is a set of vertices and edges $C \subseteq G$ such that for all $v_i$, $v_j \in C$ and $i \neq j$, $v_i$ reaches $v_j$. In accordance with this aspect of the invention, DGP connected components for the undirected graph $G$ are determined as follows: for a vertex $v_i$ that is not in a connected component, construct the component

$$C_{v_i}$$

and place $v_i$ and the vertices reachable from $v_i$ in

$$C_{v_i};$$

this set of reachable vertices is computed using the DGP reachability operations as detailed above. In the worst case scenario, i.e., when the graph has no edges, computing all components requires $n = |V|$ reachability operations such that the complexity of computing $G$'s connected components is given by $O(n^2 T)$.

With regard to so-called cycle detection, recall that, in accordance with an aspect of the invention, reachability uses OR-gates at vertices to merge multiple in-edge signals as described above. So, when a vertex lies on a cycle that is active it receives and outputs a high value. That is, the vertex's output is connected to its input via a potentially circuitous path. In accordance with this aspect of the invention, active cycles continue to be active even after removal of the source inputs since a high incoming signal suffices to set the output of an OR-gate. Further, DGP reachability, conducted with all source inputs initially high, reveals vertices that lie on a cycle when the source inputs are lowered since such vertices retain a high output value. Therefore, cycle detection can be computed in time $nT$.

Advantageously, various aspects of the invention provide a method and apparatus for implementing dynamic graph processors in reconfigurable hardware. More particularly, in accordance with the invention, a circuit representing a directed graph is maintained in a reconfigurable hardware array. Further, the circuit maintains the graph as a collection of gates and wires connecting the gates which facilitates dynamic, i.e., real-time, modification of the graph and allows the properties of the graphs to by quickly queried.

In order to further demonstrate the advantages of the invention, a series of simulations of DGP graphs will now be discussed. In particular, the following illustrative simulations are directed to DGP graph reachability in accordance with the invention as compared to a conventional uniprocessor software graph implementation. The software implementation consists of a program written in the well-known C programming language which performs a software breadth-first search ("BFS") on adjacency lists to compute reachability for every vertex in the graph. The comparison of my DGP graph to the conventional software arrangement was run over three reachability simulations for graph sizes $|V|$ = 64, 128, and 1024, respectively. Such graph sizes nominally correspond to DGP implementations in FPGA's of size 64x64 cells, 128x128 cells, and 1024x1024 cells. A single simulation consists of computing reachability from every graph vertex on random graphs nominally holding $0 < E \leq |V|^2$ edges. In accordance with this illustrative example, random graphs were created by well-known statistical sampling with replacement, therefore, for large $E$, e.g., 1024 x 1024, the generated graph will most probably have less than $E$ actual edges. Such a simulation essentially computes transitive closure over random graphs varying in edge-set size.

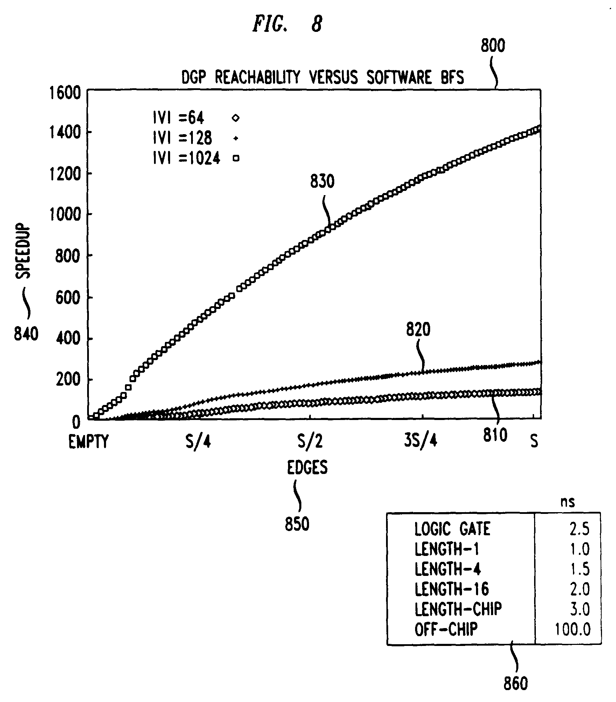

FIG. 8 shows illustrative simulation comparison results 800 of analyzing the reachability of a directed graph in accordance with the principles of the invention relative to a conventional uniprocessor software implementation. In particular, comparison results 800 show speedup 840 (i.e., how much faster reachability is determined in accordance with the invention over the conventional BFS software implementation) for DGP reachability in accordance with the invention over the software BFS on the uniprocessor. Speedup 840 is plotted (see, curve 810, curve 820, and curve 830, respectively) against the number of edges 850 for the three different graphs sizes, 64, 128, and 1024, respectively. Timing specifications for gate and routing connection delay used in each of the graph simulations is shown in box 860. Further, the illustrative simulations employed stasis detection as described above with a sampling interval of 20 Ns per tree level.

As can be readily ascertained from reviewing simulation comparison results 800, the graph reachability analysis performed in accordance with the principles of the invention significantly outperformed the conventional BFS software graph analysis. In particular, for graph sizes 64 and 128, see, curve 810 and curve 820, respectively, the maximum speedup 840 exceed two orders of magnitude. Further, speedup 840 for the graphs size 1024 (see, curve 830) exceeded three orders of magnitude which is a significant improvement in terms of processing time over the conventional approach.

As detailed above, the present invention can be embodied in the form of methods and apparatuses for practicing those methods. The invention can also be embodied in the form of program code embodied in tangible media, such as floppy diskettes, CD-ROMs, hard drives, or any other machine-readable storage medium, wherein, when the program code is loaded into and executed by a machine, such as a computer, the machine becomes an apparatus for practicing the invention. The invention can also be embodied in the form of program code, for example, in a storage medium, loaded into and/or executed by a machine, or transmitted over some transmission medium, such as over electrical wiring or cabling, through fiber optics, or via electromagnetic radiation, wherein, when the program code is loaded into and executed by a machine, such as a computer, the machine becomes an apparatus for practicing the invention. When implemented on a general-purpose processor, the program code segments combine with the processor to provide a unique device that operates analogously to specific logic circuits.

Furthermore, all examples and conditional language recited herein are principally intended expressly to be only for pedagogical purposes to aid the reader in understanding the principles of the invention and the concepts contributed by the Applicant to furthering the art, and are to be construed as being without limitation to such specifically recited examples and conditions. Moreover, all statements herein reciting principles, aspects, and embodiments of the invention, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Thus, for example, it will be appreciated by those skilled in the art that the block diagrams herein represent conceptual views of illustrative circuitry embodying the principles of the invention. Similarly, it will be appreciated that any flowcharts, flow diagrams, state transition diagrams, pseudocode, program code, and the like represent various processes which may be substantially represented in computer readable medium and so executed by a computer, machine, or processor, whether or not such computer, machine, or processor, is explicitly shown.

## Claims

1. A method for analyzing a directed graph comprising:

   defining a active-adjacency matrix ("AAM") network as a function of a plurality of vertices of the directed graph;
   mapping a representation of the directed graph into the AAM network as a function of a plurality of edges of the directed graph, each edge of the plurality of edges connecting a particular pair of vertices from the plurality of vertices; and
   analyzing at least one graph property of the directed graph using the representation of the directed graph in the AAM network.

2. The method of claim 1 wherein the AAM network includes a AAM collector network and a AAM distributor network, the AAM distributor network comprising a plurality of rows and a plurality of columns such that each column of the plurality of columns is aligned with a different one vertex of the plurality of vertices, and the AAM collector network routes at least one graph value of the directed graph to at least one column of the AAM distributor network.

3. The method of claim 2 wherein the graph value is a signal which propagates across at least one edge.

4. The method of claim 2 further comprising:

   modifying the representation of the directed graph by adding or inserting at least one edge to the AAM network.

5. The method of claim 4 wherein the at least one edge is added at a particular position in the AAM network determined as a function a row and a column.

6. The method of claim 2 wherein the AAM network is configured in a FPGA.

7. The method of claim 6 wherein at least one edge of the plurality of edges is represented as a OR-gate in the FPGA.

8. The method of claim 6 wherein the graph property is a graph property selected from the group consisting of: reachability, transitive closure, shortest unit path, connected components, or cycle detection.

9. An apparatus for representing a directed graph in hardware comprising:

   a active-adjacency matrix ("AAM") network for holding a representation of the directed graph as a function of a plurality of vertices of the directed graph; and

a processor for mapping the representation of the directed graph into the AAM network as a function of a plurality of edges of the directed graph, each edge of the plurality of edges connecting a particular pair of vertices from the plurality of vertices, and analyzing at least one graph property of the directed graph using the representation of the directed graph in the AAM network.

10. The apparatus of claim 9 wherein the AAM network includes a AAM collector network and a AAM distributor network, the AAM distributor network comprising a plurality of rows and a plurality of columns such that each column of the plurality of columns is aligned with a different one vertex of the plurality of vertices, and the AAM collector network routes at least one graph value of the directed graph to at least one column of the AAM distributor network.

11. The apparatus of claim 10 further comprising:

means for modifying the representation of the directed graph by adding or inserting at least one edge to the AAM network.

12. The apparatus of claim 11 wherein the AAM network is configured in a FPGA.

13. The apparatus of claim 12 wherein at least one edge of the plurality of edges is represented as a OR-gate in the FPGA.

14. The apparatus of claim 12 wherein the graph value is a signal which propagates across at least one edge.

15. The apparatus of claim 14 wherein the AAM network includes a stasis detection circuit for monitoring the signal at one vertex of the pair of vertices.

16. The apparatus of claim 15 wherein the stasis detection circuit comprises a AND-comparator and a register.

17. An integrated circuit comprising:

a active-adjacency matrix ("AAM") network mapped onto the integrated circuit by mapping a representation of a directed graph into the AAM network as a function of a plurality of edges of the directed graph, each edge of the plurality of edges connecting a particular pair of vertices from a plurality of vertices of the directed graph; and

a plurality of logic gates for changing the representation of the directed graph in the AAM network as a function of the plurality of edges of the directed graph, and for analyzing at least one graph property of the directed graph using the representation of the directed graph in the AAM network.

18. The apparatus of claim 17 wherein the AAM network includes a AAM collector network and a AAM distributor network, the AAM distributor network comprising a plurality of rows and a plurality of columns such that each column of the plurality of columns is aligned with a different one vertex of the plurality of vertices, and the AAM collector network routes at least one graph value of the directed graph to at least one column of the AAM distributor network.

19. The apparatus of claim 18 wherein the plurality of logic gates includes at least one OR-gate.

20. The apparatus of claim 19 wherein the integrated circuit is a FPGA.

21. A machine-readable medium having stored thereon a plurality of instructions, the plurality of instructions including instructions that, when executed by a machine, cause the machine to perform of a method for defining a active-adjacency matrix ("AAM") network as a function of a plurality of vertices of the directed graph, mapping a representation of the directed graph into the AAM network as a function of a plurality of edges of the directed graph, each edge of the plurality of edges connecting a particular pair of vertices from the plurality of vertices, and analyzing at least one graph property of the directed graph using the representation of the directed graph in the AAM network.

22. The machine-readable medium of claim 21 wherein the AAM network includes a AAM collector network and a AAM distributor network, the AAM distributor network comprising a plurality of rows and a plurality of columns such that each column of the plurality of columns is aligned with a different one vertex of the plurality of vertices, and the AAM collector network routes at least one graph value of the directed graph to at least one column of the AAM distributor network.

**23.** The machine-readable medium of claim 22 wherein the graph value is a signal which propagates across at least one edge.

*FIG. 1*

*FIG. 2*

*FIG. 3*

FIG. 4

## FIG. 5

## FIG. 6

*FIG. 7*

## FIG. 8

DGP REACHABILITY VERSUS SOFTWARE BFS

800

IVI =64    ◇
IVI =128   ◆
IVI =1024  □

830

820

840 — SPEEDUP

810

EMPTY    S/4    S/2    3S/4    S

EDGES

850

|  | ns |
|---|---|
| LOGIC GATE | 2.5 |
| LENGTH-1 | 1.0 |
| LENGTH-4 | 1.5 |
| LENGTH-16 | 2.0 |
| LENGTH-CHIP | 3.0 |
| OFF-CHIP | 100.0 |

860